# FASCICULE DE BREVET EUROPEEN

(11) **EP 1 691 242 B1**
(45) Date de publication et mention de la délivrance du brevet: **02.01.2008**
(21) Numéro de dépôt: 05405189.1
(22) Date de dépôt: 14.02.2005
(51) Int. Cl.: G04F 5/14, H03L 7/26

(54) **Procédé et dispositif de pompage optique**
Verfahren und Vorrichtung zum optischen Pumpen
Method and device for optical pumping

(43) Date de publication de la demande: 16.08.2006
(73) Titulaire: CSEM Centre Suisse d'Electronique et de Microtechnique SA Recherche et Développement, 2002 Neuchâtel (CH)
(72) Inventeur: Berthoud, Patrick, 2088 Cressier (CH); Thomann, Pierre, 2052 Fontainemelon (CH)
(74) Mandataire: GLN

(56) Documents cités:
- SHIRLEY J H ET AL: "Zeeman coherences and dark states in optically pumped cesium frequency standards" PRECISION ELECTROMAGNETIC MEASUREMENTS, 1994. DIGEST., 1994 CONFERENCE ON BOULDER, CO, USA 27 JUNE-1 JULY 1994, NEW YORK, NY, USA,IEEE, 27 juin 1994 (1994-06-27), pages 150-151, XP010123851 ISBN: 0-7803-1984-2

## Description

L'invention concerne un procédé de pompage optique d'un ensemble de particules, telles que des atomes, des ions, des molécules ou autres, permettant d'éviter la formation d'états noirs. Elle concerne également un dispositif permettant la mise en oeuvre de ce procédé.

L'invention trouve des applications intéressantes dans les résonateurs atomiques et, d'une façon générale, dans tous les instruments utilisant une source de particules et au moins un faisceau laser susceptible d'effectuer un pompage optique de ces particules. Une application particulièrement représentative est l'horloge atomique à jet de césium pompé optiquement, dont le principe de fonctionnement est décrit par la suite. Cet exemple ne saurait, toutefois, limiter la portée de l'invention, qui est définie par les revendications.

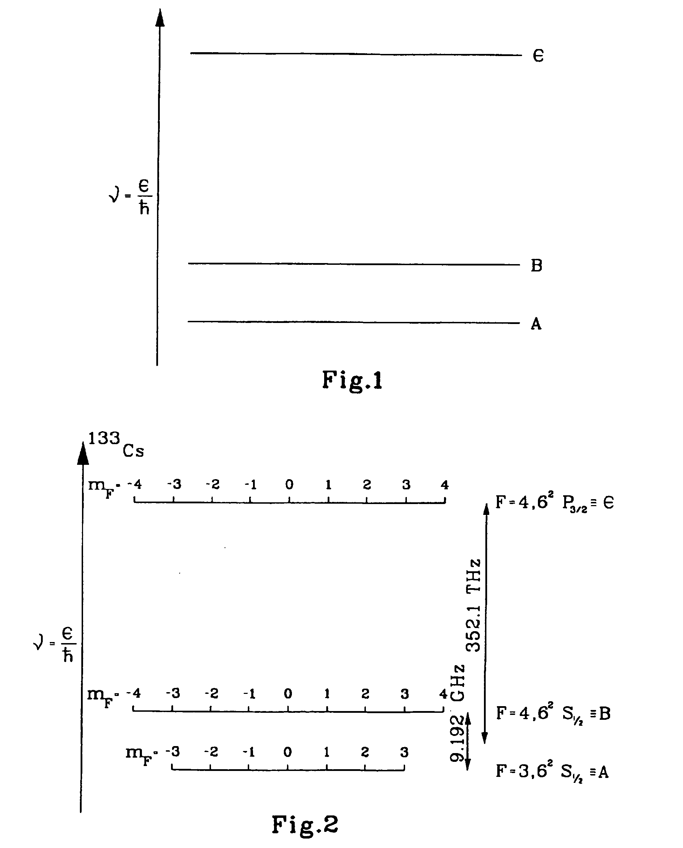

Une particule peut être caractérisée, du point de vue énergétique, par des niveaux discrets, de durée de vie variable. La figure 1 montre schématiquement et de manière simplifiée une représentation d'une particule possédant un niveau A, un niveau B et un niveau E. Les durées de vie des niveaux A et B sont longues par rapport à la durée de pompage optique, notion explicitée par la suite, qui elle-même est longue par rapport à la durée de vie du niveau E.

Comme illustré par la figure 2, dans le cas d'un atome de césium ¹³³Cs , le niveau A correspond à l'état fondamental hyperfin (6²S_{1/2}, F=3), le niveau B correspond à l'état fondamental hyperfin (6²S_{1/2}, F=4) et le niveau E correspond, par exemple, à l'état excité hyperfin (6²P_{3/2}, F=4). De plus, dans ce cas, chaque niveau est dégénéré en sous-niveaux (appelés aussi sous-niveaux Zeeman) dénommés respectivement (6²S_{1/2}; F=3 ; m_{F}=-3,-2,...,+2,+3) et (6²S_{1/2}; F=4 ; m_{F}=-4,-3,...,+3,+4) pour les deux niveaux fondamentaux, et (6²P_{3/2} ; F=4 ; m_{F}=-4,-3,...,+3,+4) pour le niveau excité.

Par pompage optique, on entend le procédé permettant de transférer une fraction ou la totalité des particules remplissant un niveau A (aussi appelé la population) vers un niveau B, ou inversement, grâce une interaction entre la lumière et les particules. On définit la durée de pompage optique comme la durée nécessaire pour transférer, par ce procédé, les particules de A vers B, ou inversement. Dans le cas de l'atome ¹³³Cs, on distingue, de plus, le procédé de pompage optique hyperfin du pompage optique Zeeman. Le pompage optique hyperfin dépeuple l'un des niveaux fondamentaux (6²S_{1/2}, F=3) ou (6²S_{1/2}, F=4) au profit de l'autre par une interaction optique via, par exemple, l'état excité (6²P_{3/2}, F=4), aucune distinction n'étant faite des sous-niveaux Zeeman. Le pompage optique Zeeman dépeuple certains sous-niveaux Zeeman au profit d'un seul sous-niveau ou d'une superposition de sous-niveaux Zeeman d'un niveau hyperfin fondamental, par une ou plusieurs interactions optiques via un ou plusieurs états excités.

Expérimentalement, dans le cas de l'atome de ¹³³Cs, le pompage optique hyperfin est réalisé en illuminant une collection de particules (en jet ou en cellule) par un faisceau optique émis par une lampe à décharge ou un laser, de fréquence correspondant à une ou plusieurs transitions optiques permises entre un niveau fondamental (6²S_{1/2}, F=3) ou (6²S_{1/2}, F=4) et un ou plusieurs niveaux excités, par exemple (6²P_{3/2}, F=4). Avec une lumière polarisée émise par un laser, des cohérences peuvent apparaître entre les sous-niveaux Zeeman du niveau fondamental couplé au laser, donnant lieu à des états dits « noirs », c'est-à-dire transparents au processus de pompage optique hyperfin. Dimarcq et al. (IEEE Transactions on Instrumentation and Measurement, 42 (2), April 1993, 115-120) ont démontré, sur une expérience de jet atomique de césium pompé par laser, que le bruit ajouté par la fraction résiduelle d'atomes piégés dans les états noirs pouvait réduire considérablement le rapport signal à bruit atomique et donc devenir préjudiciable à la performance d'un résonateur atomique.

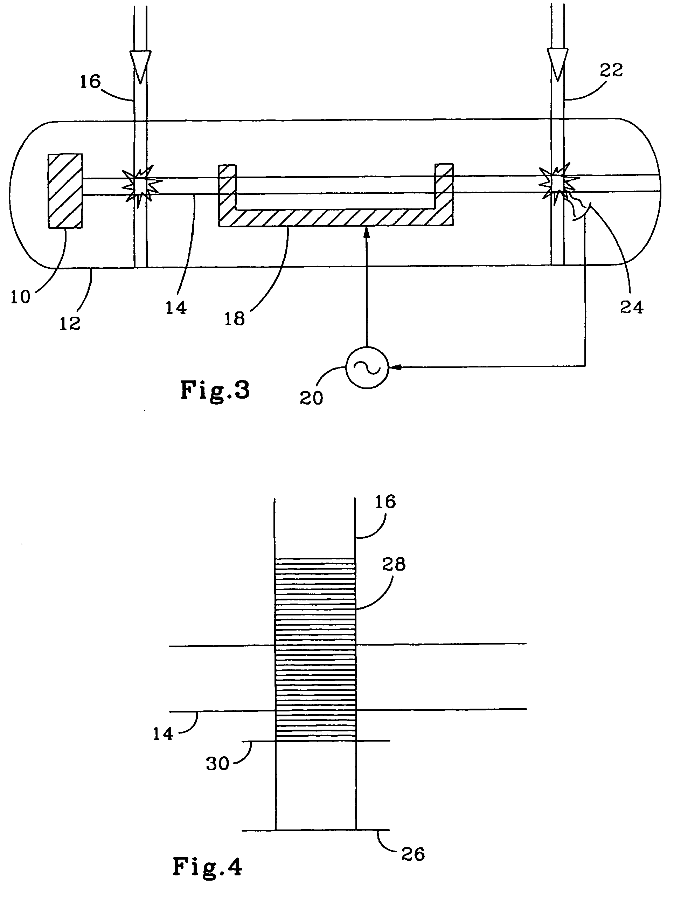

La structure de principe d'une horloge atomique à jet de césium pompé optiquement est illustrée par la figure 3. Une source 10, disposée à l'intérieur d'une enceinte à haut vide 12, produit un jet de césium atomique 14, rapide ou lent. Un jet rapide est, par exemple, généré par un four, alors qu'un jet lent est produit par une source d'atomes ralentis ou refroidis par laser. Un premier faisceau laser 16, dit 'de préparation', croisant le jet atomique 14 en sortie de la source 10, réalise l'inversion de population nécessaire entre les deux états hyperfins fondamentaux par un processus de pompage optique hyperfin ou Zeeman. Les atomes du jet 14 subissent ensuite une transition entre les deux états hyperfins fondamentaux dans une cavité résonnante 18 injectée par une micro-onde issue d'un oscillateur local 20. Un second faisceau laser 22, dit 'd'interrogation', croisant le jet atomique 14 en sortie de la cavité résonnante 18, détecte par un processus de pompage optique hyperfin ou Zeeman, les atomes ayant subi constructivement la transition micro-onde. Un détecteur 24, situé en regard de la zone d'interrogation du jet atomique 14, collecte la lumière de fluorescence réémise par les atomes ayant subi les procédés de pompage optique. L'intensité de ce signal lumineux renseigne sur l'accord de fréquence entre la micro-onde injectée dans la cavité résonnante et la transition atomique entre les deux niveaux fondamentaux. Le signal issu du détecteur 24 permet, de plus, l'asservissement de la fréquence micro-onde de l'oscillateur local 20, par un système adéquat. Les deux faisceaux optiques de préparation 16 et d'interrogation 22 peuvent provenir d'une source unique ou de sources multiples. Ils peuvent, en outre, résulter d'une superposition de plusieurs faisceaux optiques de fréquences différentes.

Comme mentionné précédemment, le rapport signal sur bruit de la lumière de fluorescence en zone d'interrogation, qui conditionne la performance de stabilité de fréquence du résonateur atomique, est dégradé par la présence d'atomes piégés dans des états noirs. Plusieurs solutions permettant de les supprimer existent d'ores et déjà, mais présentent toutes un certain nombre d'inconvénients.

Une première possibilité, décrite dans un article de Giordano et al. (IEEE Transactions on Ultrasonics, Ferroelectrics, and Frequency Control, 38 (4), July 1991, 350-357) consiste à établir un champ magnétique statique intense (supérieur à 300mG) d'orientation adéquate, soit perpendiculaire à l'axe de la polarisation dans le cas d'une polarisation linéaire des faisceaux laser (16,22) dans les deux régions de pompage optique hyperfin. Ceci a pour effet de redistribuer les populations Zeeman à l'intérieur de chaque niveau hyperfin fondamental, et donc de détruire les états noirs. Cette solution, bien qu'efficace, s'avère difficile et complexe à mettre en oeuvre du fait de la nécessité de plusieurs zones contiguës de champ magnétique d'intensités très différentes (dix fois plus faible entre les zones de pompages que dans celles-ci).

Une seconde solution, décrite dans un article de Dimarcq et al. (Journal of Applied Physics 69 (3), February 1991, 1158-1162), consiste à choisir une transition de pompage optique ne créant pas d'états noirs comme, par exemple, la transition 3-4π (D1) à 894 nm pour l'atome ¹³³Cs. Malheureusement, le choix d'une telle transition réduit fortement les degrés de liberté pour l'optimisation d'autres paramètres (efficacité de pompage optique hyperfin et taux de fluorescence). De plus, la disponibilité de sources laser performantes à ces longueurs d'onde n'est pas garantie.

Une troisième solution, décrite dans l'article de Shirley et al. (Proceedings of the 1994 IEEE Precision on Electromagnetic Measurements, 150-151), consiste à perturber la polarisation du faisceau laser, à l'origine du piégeage des atomes dans les 'états noirs'. Comme illustré par la figure 4, sur laquelle la zone de préparation est fortement agrandie, cette perturbation est réalisée en créant une onde stationnaire optique possédant un gradient de polarisation sensiblement parallèle à la direction de propagation du faisceau laser 16. L'onde stationnaire est réalisée en rétro-réfléchissant le faisceau laser 16 linéairement polarisé à l'aide d'un miroir plan 26 situé sur le trajet du faisceau laser 16, en aval de la zone de pompage. Le gradient de polarisation périodique longitudinal 28 est réalisé en insérant une lame quart d'onde 30 entre le miroir plan 26 et le jet atomique 14. Dans une telle onde stationnaire, la polarisation change significativement tous les quarts de longueur d'onde optique (0.2 µm pour le ¹³³Cs). Cette solution, certes élégante, présente néanmoins l'inconvénient d'introduire deux éléments optiques supplémentaires par rapport à la configuration standard. De plus, elle peut n'être pas totalement efficace si le gradient de polarisation est parfaitement perpendiculaire au jet atomique. Dans ce cas, les atomes peuvent traverser le faisceau laser sans subir de variation significative de polarisation de la lumière, et les états noirs ne sont pas détruits, ou le sont incomplètement,.

La présente invention apporte une nouvelle solution pour supprimer les états noirs produits par le procédé de pompage optique en proposant un procédé de pompage optique permettant de brouiller la polarisation, et des moyens pour le réaliser. Ce procédé a l'avantage de sa simplicité, ne dépend pas du choix et du nombre de fréquences optiques et ne nécessite pas de champ magnétique intense.

De façon plus précise, l'invention concerne un procédé de pompage optique de particules comme défini dans la revendication indépendante 1.

L'invention concerne également un dispositif pour la mise en oeuvre de ce procédé comme défini dans la revendication indépendante 17.

D'autres caractéristiques de l'invention apparaîtront plus clairement à la lecture de la description qui suit, faite en référence aux dessins annexés, dans lesquels :
- les figures 5 et 7 illustrent, en relation avec les figures 1 à 4 déjà mentionnées, deux modes de réalisation de pompage optique selon l'invention, et
- la figure 6 illustre des variantes d'éléments optiques destinés à ce pompage optique.

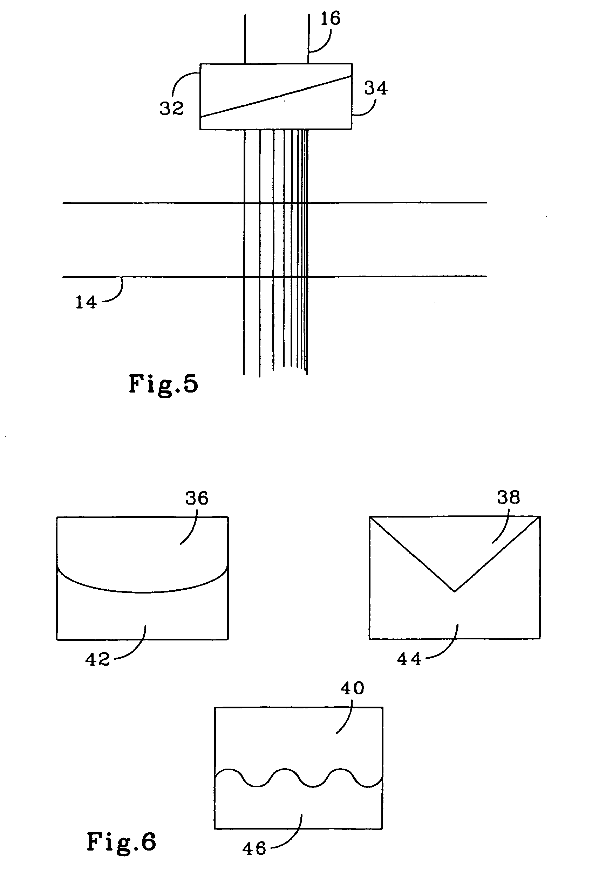

La figure 5 illustre schématiquement la zone de préparation du jet atomique en vue agrandie. Le faisceau 16 croise le jet atomique 14 afin de réaliser le pompage optique. Une lame biréfringente 32, par exemple en quartz cristallin, à faces non parallèles, est insérée sur le trajet du faisceau 16, en amont du jet atomique 14. L'orientation de l'axe optique de la lame 32 par rapport à la polarisation du faisceau incident 16 est telle qu'elle crée un maximum d'ellipticité de la polarisation sortante, idéalement 45° entre l'axe de la polarisation linéaire incidente et les axes principaux de la lame biréfringente. Le gradient de phase accumulée par l'onde plane incidente 16 due à la variation d'épaisseur de la lame 32, combinée à l'ellipticité de la polarisation due au double indice de réfraction de la lame biréfringente 32, produit un gradient de polarisation du faisceau lumineux transverse à la direction de propagation du faisceau lumineux 16. De plus, l'orientation du plan de symétrie de la lame 32 est telle que le gradient de polarisation du faisceau 16 est sensiblement parallèle à la direction de déplacement des particules.

Comme la polarisation varie ainsi de façon continue le long de la direction de propagation atomique, les atomes interagissent nécessairement avec une polarisation variable sur leur trajet, conduisant à l'élimination des états noirs.

On notera que le gradient de polarisation du faisceau lumineux introduit par la lame biréfringente 32 est directement lié à son gradient d'épaisseur, à sa biréfringence et à la longueur d'onde du faisceau incident 16. Pour détruire les états noirs, il faut que la polarisation change de manière significative sur la distance parcourue par la particule durant un cycle de pompage optique.

Par ailleurs, la lame de quartz cristallin 32 est avantageusement associée à une lame de compensation 34, neutre du point de vue de la polarisation, par exemple en silice amorphe, qui permet de compenser la déviation du faisceau lumineux 16 introduite par la lame 32.

La lame biréfringente 32 à faces non parallèles n'est qu'un exemple représentatif de dispositif permettant le brouillage de la polarisation selon l'invention. D'autres éléments d'optique, représentés sur la figure 6, présentent les caractéristiques nécessaires et suffisantes pour réaliser un tel brouillage, à savoir la biréfringence et la variation d'épaisseur selon un axe transverse au faisceau lumineux 16. Ces éléments sont, par exemple, une lentille 36, un cône de révolution 38, ou une lame à surface aléatoire 40. Tous sont avantageusement associés à un élément de compensation, respectivement 42, 44 et 46, du type de la lame 34, destiné à neutraliser l'effet de l'élément sur la géométrie du faisceau 16.

Contrairement à la lame biréfringente 32 à faces non parallèles, ces éléments 36, 38 et 40 d'épaisseur variable transversalement, ne présentent pas un plan de symétrie unique, mais une symétrie de révolution axiale ou aléatoire. Leur orientation par rapport à la polarisation du faisceau incident 16 peut être arbitraire.

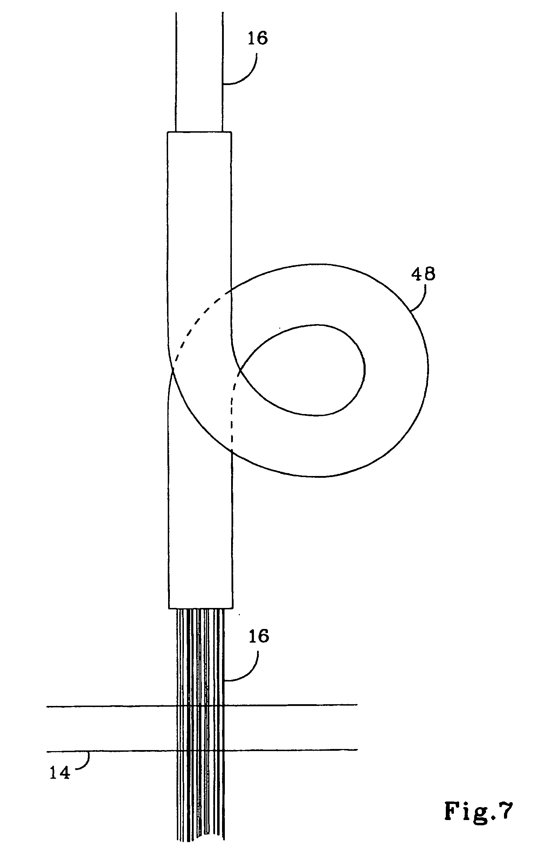

Le procédé de brouillage selon l'invention peut également être réalisé à l'aide d'autres éléments optiques, comme illustré par la figure 7. Pour cette réalisation, une fibre optique multi-mode 48 est interposée sur le trajet du faisceau laser 16, en amont du jet atomique 14. Dans ce type de fibre optique, la polarisation du faisceau laser incident n'est pas conservée en sortie de la fibre, du fait de la dispersion de la vitesse de propagation des différents modes de la fibre. Cet effet est d'autant plus perceptible que la fibre 48 est longue et contrainte mécaniquement (petit rayon de courbure) ou thermiquement (gradient de température). L'interférence entre les différents modes de polarisation est fortement dépendante de la position transversale dans le faisceau sortant de la fibre. Une solution avantageuse consiste à donc enrouler la fibre optique 48 sur elle même de façon suffisamment serrée pour avoir un mélange de polarisations suffisant en sortie.

Par ailleurs, une optique intégrée du type MOEMS (Mechanical Optical Electrical Micro-System) constitue une possibilité d'avenir. Sur ce type de dispositif miniaturisé, le laser et l'optique sont associés sur un même substrat.

Le brouillage de la polarisation est obtenu grâce à des éléments possédant une fonction identique à la lame biréfringente ou à la fibre optique, et intégrés sur le substrat.

On notera également que le pompage optique selon l'invention peut s'appliquer à la zone d'interrogation de la même manière qu'à la zone de préparation.

Enfin, le procédé est applicable à des particules autres que des atomes, telles que des molécules, des ions ou des agrégats de telles particules, se déplaçant non seulement en jet, mais également en cellule.

## Revendications

1. Procédé de pompage optique de particules (14) consistant à les faire transiter d'un niveau de longue durée de vie à un autre niveau de longue durée de vie, via un niveau de courte durée de vie, par interaction avec un rayonnement lumineux (16, 22) émis par une source laser, **caractérisé en ce que** ledit rayonnement subit préalablement une dépolarisation selon une direction significativement perpendiculaire à sa direction de propagation, de manière à réduire le piégeage desdites particules (14) dans des états noirs.

2. Procédé de pompage optique selon la revendication 1, **caractérisé en ce que** lesdites particules (14) sont émises par une source (10) sensiblement suivant une direction déterminée.

3. Procédé de pompage optique selon la revendication 2, **caractérisé en ce que** ladite dépolarisation est sensiblement parallèle à ladite direction des particules (14).

4. Procédé de pompage optique selon la revendication 1, **caractérisé en ce que** lesdites particules (14) sont émises par une source (10) suivant des directions aléatoires.

5. Procédé de pompage optique selon l'une des revendications 1 à 4,
**caractérisé en ce que** ladite dépolarisation est sensiblement un gradient de polarisation.

6. Procédé de pompage optique selon la revendication 5, **caractérisé en ce que** ledit gradient de polarisation est réalisé à l'aide d'un élément d'optique biréfringent (32, 36, 38, 40) d'épaisseur variable, interposé sur le trajet dudit rayonnement lumineux (16, 22).

7. Procédé de pompage optique selon la revendication 6, **caractérisé en ce que** ledit élément d'optique d'épaisseur variable est réalisé à l'aide d'une lame dont les faces sont non parallèles (32).

8. Procédé de pompage optique selon la revendication 6, **caractérisé en ce que** ledit élément d'optique d'épaisseur variable est réalisé à l'aide d'une lame à symétrie de révolution axiale (36, 38).

9. Procédé de pompage optique selon l'une des revendications 6 à 8, **caractérisé en ce que** ledit élément d'optique (32, 36, 38, 40) est en quartz cristallin.

10. Procédé de pompage optique selon l'une des revendications 1 à 4, **caractérisé en ce que** ladite dépolarisation est sensiblement un mélange de polarisations aléatoire.

11. Procédé de pompage optique selon la revendication 10, **caractérisé en ce que** ledit mélange de polarisations est réalisé à l'aide d'une fibre optique multi-modes (48) transportant ledit rayonnement lumineux (16, 22).

12. Procédé de pompage optique selon l'une des revendications 1 à 11, **caractérisé en ce que** lesdites particules sont des atomes.

13. Procédé de pompage optique selon la revendication 12, **caractérisé en ce que** lesdits atomes sont des atomes de césium.

14. Procédé de pompage optique selon l'une des revendications 1 à 11 **caractérisé en ce que** lesdites particules sont des molécules.

15. Procédé de pompage optique selon l'une des revendications 1 à 11, **caractérisé en ce que** lesdites particules sont des ions.

16. Procédé de pompage optique selon l'une des revendications 1 à 11, **caractérisé en ce que** lesdites particules sont des agrégats.

17. Dispositif pour la mise en oeuvre du procédé selon l'une des revendications 1 à 16, comportant :
- une source (10) émettant des particules (14), et
- au moins un laser produisant au moins un rayonnement lumineux polarisé (16, 22) agencé pour interagir avec lesdites particules (14) et pour effectuer un pompage optique desdites particules (14) consistant à les faire transiter d'un niveau de longue durée de vie à un autre niveau de longue durée de vie, via un niveau de courte durée de vie ;
ledit dispositif étant **caractérisé en ce qu'**il comporte, en outre, des moyens (32, 34, 48) agencés pour réaliser, préalablement à son interaction avec lesdites particules (14), une dépolarisation dudit rayonnement (16, 22) selon une direction significativement perpendiculaire à sa direction de propagation.

18. Dispositif selon la revendication 17, **caractérisé en ce qu'**il comporte, en outre, une cavité micro-onde (18) destinée à faire passer lesdites particules d'un niveau de longue durée de vie à un autre niveau de longue durée de vie, et un détecteur (24), ces deux éléments formant ensemble, avec ladite source (10) et ledit laser, un résonateur atomique.

19. Dispositif selon l'une des revendications 17 et 18, **caractérisé en ce que** lesdites particules (14) sont émises par ladite source (10) sensiblement suivant une direction déterminée.

20. Dispositif selon la revendication 19, **caractérisé en ce que** ladite dépolarisation est sensiblement parallèle à ladite direction des particules (14).

21. Dispositif selon l'une des revendications 17 à 20, **caractérisé en ce que** lesdits moyens sont un élément d'optique biréfringent (32, 36, 38, 40) d'épaisseur variable, interposé sur le trajet dudit rayonnement lumineux (16, 22).

22. Dispositif selon la revendication 21, **caractérisé en ce que** ledit élément d'optique d'épaisseur variable est réalisé à l'aide d'une lame dont les faces sont non parallèles (32).

23. Dispositif selon la revendication 22, **caractérisé en ce que** ledit élément d'optique d'épaisseur variable est réalisé à l'aide d'une lame à symétrie de révolution axiale (36, 38).

24. Dispositif selon l'une des revendications 21 à 23, **caractérisé en ce que** ledit élément d'optique (32, 36, 38, 40) est en quartz cristallin.

25. Dispositif selon l'une des revendications 21 à 24, **caractérisé en ce que** ledit élément d'optique (32, 36, 38, 40) est associée à une lame de compensation (34, 42, 44, 46) neutre du point de vue de la polarisation.

26. Dispositif selon l'une des revendications 17 à 20 **caractérisé en ce que** lesdits moyens sont une fibre optique multi-mode (48) interposée sur le trajet dudit rayonnement lumineux (16, 22).

## Claims

1. A method for optical pumping of particles (14) consisting of having them transit from a long-lived level to another long-lived level, via a short-lived level, by interaction with a light radiation (16, 22) emitted by a laser source, **characterized in that** said radiation undergoes beforehand depolarization along a direction significantly perpendicular to its direction of propagation, so as to reduce the trapping of said particles (14) in black states.

2. The optical pumping method according to claim 1, **characterized in that** said particles (14) are emitted by a source (10) substantially along a determined direction.

3. The optical pumping method according to claim 2, **characterized in that** said depolarization is substantially parallel to said direction of the particles (14).

4. The optical pumping method according to claim 1, **characterized in that** said particles (14) are emitted by a source (10) along random directions.

5. The optical pumping method according to any of claims 1 to 4, **characterized in that** said depolarization is substantially a polarization gradient.

6. The optical pumping method according to claim 5, **characterized in that** said polarization gradient is achieved by means of a birefringent optical component (32, 36, 38, 40) with variable thickness, interposed on the path of said light radiation (16, 22).

7. The optical pumping method according to claim 6, **characterized in that** said optical component of variable thickness is produced by means of a plate, the faces of which are non-parallel (32).

8. The optical pumping method according to claim 6, **characterized in that** said optical component of variable thickness is produced by means of a plate with axial symmetry of revolution (36, 38).

9. The optical pumping method according to any of claims 6 to 8, **characterized in that** said optical component (32, 36, 38, 40) is in crystalline quartz.

10. The optical pumping method according to any of claims 1 to 4, **characterized in that** said depolarization is substantially a random mixture of polarizations.

11. The optical pumping method according to claim 10, **characterized in that** said mixture of polarizations is produced by means of a multimode optical fiber(48) transporting said light radiation (16, 22).

12. The optical pumping method according to any of claims 1 to 11, **characterized in that** said particles are atoms.

13. The optical pumping method according to claim 12, **characterized in that** said atoms are cesium atoms.

14. The optical pumping method according to any of claims 1 to 11, **characterized in that** said particles are molecules.

15. The optical pumping method according to any of claims 1 to 11, **characterized in that** said particles are ions.

16. The optical pumping method according to any of claims 1 to 11, **characterized in that** said particles are aggregates.

17. A device for applying the method according to any of claims 1 to 16, including :
- a source (10) emitting particles (14), and
- at least one laser producing at least one polarized light radiation (16, 22) arranged so as to interact with said particles (14) and to perform optical pumping of said particles (14) consisting of having them transit from a long-lived level to another long-lived level, via a short-lived level;
said device being **characterized in that** it further includes means (32, 34,48) arranged so as to perform, beforehand to interact with said particles (14), depolarization of said radiation (16, 22) along a direction significantly perpendicular to its direction of propagation.

18. The device according to claim 17, **characterized in that** it further includes a microwave cavity (18) intended for having said particles pass from a long-lived level to another long-lived level, and a detector (24), both of these components forming together with said source (10) and said laser, an atomic resonator.

19. The device according to any of claims 17 and 18, **characterized in that** said particles (14) are emitted by said source (10) substantially along a determined direction.

20. The device according to claim 19, **characterized in that** said depolarization is substantially parallel to said direction of the particles (14).

21. The device according to any of claims 17 to 20, **characterized in that** said means are a birefringent optical component (32, 36, 38, 40) with variable thickness, interposed on the path of said light radiation (16, 22).

22. The device according to claim 21, **characterized in that** said optical component with variable thickness is produced by means of a plate, the faces of which are non parallel (32).

23. The device according to claim 22, **characterized in that** said optical component with variable thickness is produced by means of a plate with axial symmetry of revolution (36, 38).

24. The device according to any of claims 21 to 23, **characterized in that** said optical component (32, 36, 38, 40) is in crystalline quartz.

25. The device according to any of claims 21 to 24, **characterized in that** said optical component (32, 36, 38, 40) is associated with a compensation plate (34, 42, 44, 46), neutral from the point of view of polarization.

26. The device according to any of claims 17 to 20, **characterized in that** said means are a multimode optical fiber (48) interposed on the path of said light radiation (16, 22).

## Patentansprüche

1. Verfahren zum optischen Pumpen von Teilchen (14), das darin besteht, sie von einem Niveau langer Lebensdauer in ein anderes Niveau langer Lebensdauer zu überführen, über ein Niveau kurzer Lebensdauer, durch Interaktion mit einer Lichtstrahlung (16, 22), die von einer Laserquelle ausgesendet wird, **dadurch gekennzeichnet, dass** die Strahlung zuvor einer Depolarisation unterzogen wird in einer Richtung im Wesentlichen zu ihrer Ausbreitungsrichtung, um das Einfangen der Teilchen (14) in schwarzen Zuständen zu reduzieren.

2. Optisches Pumpverfahren nach Anspruch 1, **dadurch gekennzeichnet, dass** die Teilchen (14) von einer Quelle (10) etwa in eine bestimmte Richtung ausgesendet werden.

3. Optisches Pumpverfahren nach Anspruch 2, **dadurch gekennzeichnet, dass** die Depolarisation etwa parallel zur Richtung der Teilchen (14) ist.

4. Optisches Pumpverfahren nach Anspruch 1, **dadurch gekennzeichnet, dass** die Teilchen (14) von einer Quelle (10) in zufällige Richtungen ausgesendet werden.

5. Optisches Pumpverfahren nach einem der Ansprüche 1 bis 4, **dadurch gekennzeichnet, dass** die Depolarisation etwa ein Polarisationsgradient ist.

6. Optisches Pumpverfahren nach Anspruch 5, **dadurch gekennzeichnet, dass** der Polarisationsgradient mit Hilfe eines doppelbrechenden optischen Elements (32, 36, 38, 40) variabler Dicke durchgeführt wird, das in den Weg der Lichtstrahlung (16, 22) zwischengestellt ist.

7. Optisches Pumpverfahren nach Anspruch 6, **dadurch gekennzeichnet, dass** das optische Element variabler Dicke mit Hilfe einer Platte ausgeführt ist, deren Seiten nicht parallel (32) sind.

8. Optisches Pumpverfahren nach Anspruch 6, **dadurch gekennzeichnet, dass** das optische Element variabler Dicke mit Hilfe einer Platte mit axialer Rotationssymmetrie (36, 38) ausgeführt ist.

9. Optisches Pumpverfahren nach einem der Ansprüche 6 bis 8, **dadurch gekennzeichnet, dass** das optische Element (32, 36, 38, 40) aus kristallinem Quarz ist.

10. Optisches Pumpverfahren nach einem der Ansprüche 1 bis 4, **dadurch gekennzeichnet, dass** die Depolarisation etwa eine zufällige Polarisationsmischung ist.

11. Optisches Pumpverfahren nach Anspruch 10, **dadurch gekennzeichnet, dass** die Polarisationsmischung mit Hilfe einer optischen Mehrmoden-Faser (48) ausgeführt wird, die die Lichtstrahlung (16, 22) transportiert.

12. Optisches Pumpverfahren nach einem der Ansprüche 1 bis 11, **dadurch gekennzeichnet, dass** die Teilchen Atome sind.

13. Optisches Pumpverfahren nach Anspruch 12, **dadurch gekennzeichnet, dass** die Atome Zäsiumatome sind.

14. Optisches Pumpverfahren nach einem der Ansprüche 1 bis 11, **dadurch gekennzeichnet, dass** die Teilchen Moleküle sind.

15. Optisches Pumpverfahren nach einem der Ansprüche 1 bis 11, **dadurch gekennzeichnet, dass** die Teilchen Ionen sind.

16. Optisches Pumpverfahren nach einem der Ansprüche 1 bis 11, **dadurch gekennzeichnet, dass** die Teilchen Aggregationen sind.

17. Vorrichtung zur Umsetzung des Verfahrens nach einem der Ansprüche 1 bis 16, umfassend :
- eine Quelle (10), die Teilchen (14) aussendet, und
- mindestens einen Laser, der mindestens eine polarisierte Lichtstrahlung (16, 22) produziert, ausgelegt so dass sie mit den Teilchen (14) interakt und sie ein optisches Pumpen von den Teilchen (14) leistet, das darin besteht, sie von einem Niveau langer Lebensdauer in ein anderes Niveau langer Lebensdauer zu überführen, über ein Niveau kurzen Lebensdauer;
**dadurch gekennzeichnet, dass** sie weiterhin Mittel (32, 34, 48) umfasst, die zum Durchführen einer Depolarisation der Strahlung (16, 22) in eine Richtung im Wesentlichen senkrecht zu ihrer Ausbreitungsrichtung ausgelegt sind, bevor sie mit den Teilchen (14) interakt.

18. Vorrichtung nach Anspruch 17, **dadurch gekennzeichnet, dass** sie weiterhin einen Mikrowellenhohlraum (18) umfasst, der dazu bestimmt ist, die Teilchen von einem Niveau langer Lebensdauer in ein anderes Niveau langer Lebensdauer zu überführen, und einen Detektor (24), wobei diese zwei Elemente gemeinsam mit der Quelle (10) und dem Laser einen Atomresonator bilden.

19. Vorrichtung nach einem der Ansprüche 17 und 18, **dadurch gekennzeichnet, dass** die Teilchen (14) von der Quelle (10) etwa in eine bestimmte Richtung ausgesendet werden.

20. Vorrichtung nach Anspruch 19, **dadurch gekennzeichnet, dass** die Depolarisation etwa parallel zur Richtung der Teilchen (14) ist.

21. Vorrichtung nach einem der Ansprüche 17 bis 20, **dadurch gekennzeichnet, dass** die Mittel ein doppelbrechendes optisches Element (32, 36, 38, 40) variabler Dicke sind, das in den Weg der Lichtstrahlung (16, 22) zwischengestellt ist.

22. Vorrichtung nach Anspruch 21, **dadurch gekennzeichnet, dass** das optische Element variabler Dicke mit Hilfe einer Platte ausgeführt ist, deren Seiten nicht parallel (32) sind.

23. Vorrichtung nach Anspruch 22, **dadurch gekennzeichnet, dass** das optische Element variabler Dicke mit Hilfe einer Platte mit axialer Rotationssymmetrie (36, 38) ausgeführt ist.

24. Vorrichtung nach einem der Ansprüche 21 bis 23, **dadurch gekennzeichnet, dass** das optische Element (32, 36, 38, 40) aus kristallinem Quarz ist.

25. Vorrichtung nach einem der Anspruch 21 bis 24, **dadurch gekennzeichnet, dass** das optische Element (32, 36, 38, 40) mit einer vom Standpunkt der Polarisation neutralen Kompensationsplatte (34, 42, 44, 46) verbunden ist.

26. Vorrichtung nach einem der Ansprüche 17 bis 20, **dadurch gekennzeichnet, dass** die Mittel eine optische Multimoden-Faser (48) sind, die in den Weg der Lichtstrahlung (16, 22) zwischengestellt ist.
